(19) Europäisches Patentamt
European Patent Office
Office européen des brevets

(11) **EP 2 029 692 B1**

(12) **EUROPÄISCHE PATENTSCHRIFT**

(45) Veröffentlichungstag und Bekanntmachung des Hinweises auf die Patenterteilung:
**11.01.2012 Patentblatt 2012/02**

(21) Anmeldenummer: **06842275.7**

(22) Anmeldetag: **30.11.2006**

(51) Int Cl.:
*C09K 5/10* (2006.01)     *C08F 16/06* (2006.01)
*C08K 3/00* (2006.01)

(86) Internationale Anmeldenummer:
**PCT/IB2006/003769**

(87) Internationale Veröffentlichungsnummer:
**WO 2007/080447 (19.07.2007 Gazette 2007/29)**

(54) **WÄRMETRANSPORTIERENDES MEDIUM SOWIE HEIZ- ODER KÜHLSYSTEM MIT EINEM SOLCHEN MEDIUM**

HEAT TRANSPORT MEDIUM AND HEATING OR COOLING SYSTEM COMPRISING SAID MEDIUM

MILIEU DE TRANSFERT THERMIQUE ET SYSTEME DE CHAUFFAGE ET DE REFROIDISSEMENT COMPRENANT UN TEL MILIEU

(84) Benannte Vertragsstaaten:
**DE FR GB**

(30) Priorität: **09.01.2006 DE 102006001335**

(43) Veröffentlichungstag der Anmeldung:
**04.03.2009 Patentblatt 2009/10**

(73) Patentinhaber: **Curamik Electronics GmbH
92676 Eschenbach (DE)**

(72) Erfinder:
• **HAMMEL, Ernst
A-1140 Wien (AT)**
• **TANG, Xinhe
A-1220 Wien (AT)**

(74) Vertreter: **Graf, Helmut et al
Graf Glück Habersack Kritzenberger
Postfach 10 08 26
93008 Regensburg (DE)**

(56) Entgegenhaltungen:
**EP-A1- 1 055 719      GB-A- 1 066 333
US-A1- 2003 100 578    US-A1- 2004 209 782
US-A1- 2005 037 082    US-A1- 2005 092 467**

• **DATABASE WPI Week 198733 Derwent Publications Ltd., London, GB; AN 1987-232363 XP002446817 & JP 62 156910 A (DAICEL CHEM IND LTD) 11. Juli 1987 (1987-07-11)**
• **DATABASE WPI Week 200451 Derwent Publications Ltd., London, GB; AN 2004-528485 XP002446818 & JP 2004 185983 A (TOYOBO KK) 2. Juli 2004 (2004-07-02)**

EP 2 029 692 B1

**Beschreibung**

Die Erfindung bezieht sich auf ein Heiz- oder Kühlsystem gemäß Oberbegriff Patentanspruch 1.

Die Verwendung von flüssigen Wärme transportierenden Medien, insbesondere auch in aktiven Kühlsystemen sind bekannt. Bekannt ist hierbei insbesondere auch die Verwendung von Wärme transportierenden Medien, die als Basiskomponente Wasser gegebenenfalls mit einem weiteren Zusatz, beispielsweise mit Polyvinylalkohol (PVA) als Gefrierschutz- oder Korrosionsschutzzusatz enthalten (EP 1055719 A1).

Bekannt sind weiterhin Kühlflüssigkeiten für Dieselmotoren (GB-A-1066333), die in wässriger Lösung Alkohole und eine organische Verbindung enthalten, beispielsweise in Form von Polyvinylalkohol.

Bekannt sind weiterhin Suspensionen mit verbesserten thermischen Eigenschaften (US2005/037082 A1), die u.a. aus destilliertem Wasser und Nanofasern bestehen und denen Polyvinylalkohollösungen zugefügt sind. Durch den Zusatz an Nanofasern wird der innere Wärmewiderstand dieser Suspensionen reduziert, wodurch bei Verwendung als Wärme transportierendes Medium der Wärmeübergang zwischen der Suspension und einem zu kühlenden Funktionselement verbessert werden kann. Nachteilig ist aber die fehlende Stabilität solcher Suspensionen. Vielmehr neigt das Nanofasermaterial zum Ausfällen oder Absetzen oder zum Verklumpen.

Bekannt sind weiterhin elektrisch leitenden Zusammensetzungen, die in einer organischen oder anorganischen Matrix Carbon-Nanofasern enthalten und beispielsweise durch Zugabe dieser Fasern in eine wässrige Lösung aus Polyanilin und Mischen mit einer wässrigen Lösung aus Polyvinylalkohol hergestellt werden, und zwar zum Aufbringen von dünnen elektrisch leitenden Schichten auf Gegenstände (JP 2004/185983).

Aufgabe der Erfindung ist es, ein Heiz- oder Kühlsystem mit einem flüssigen, Wärme transportierendes Medium aufzuzeigen, welches bei niedrigen thermischen Widerstand eine verbesserte Kühl- oder Heizwirkung ermöglicht. Zur Lösung dieser Aufgabe ist ein Heiz- oder Kühlsystem entsprechend dem Patentanspruch 1 ausgebildet.

Das Wärme transportierende Medium grundsätzlich besteht aus der Basiskomponente aus Wasser mit einem ausreichenden Zusatz an einem Polyvinylalkohol (nachstehend PVA) und Nanofasermaterial, insbesondere auf Kohlenstoffbasis. Bevorzugt wird das Nanofasermaterial zunächst mit einer konzentrierten Lösung aus PVA und einem geeigneten Lösungsmittel, beispielsweise Wasser vorbehandelt und auf diese Weise mit PVA versehen, und zwar durch Mischen mit der PVA-Lösung. Das so vorbehandelte Nanofasermaterial wird dann in die Basiskomponente, die beispielsweise aus Wasser und einer weiteren Komponente besteht eingebracht.

In Weiterbildung der Erfindung ist das Wärme transportierende Medium beispielsweise so ausgebildet,

dass der wenigstens eine Zusatz von einem mit einem Polyvinylalkohol vorbehandelten bzw. versehenen Nanofasermaterial gebildet ist, und/oder

dass das Nanofasermaterial durch Vermischen mit einer Polyvinylalkohol enthaltenden Vorbehandlungslösung vorbehandelt ist, und/oder

dass die Vorbehandlungslösung 5 Gewichts% Polyvinylalkohol enthält, und/oder

dass die Vorbehandlungslösung eine gesättigte Polyvinylalkohol-Lösung ist, und/oder

dass das Nanofasermaterial Nanofasern und/oder Nanotubes enthält, und/oder

dass das Nanofasermaterial ein solches auf Carbon- oder Kohlenstoffbasis ist, und/oder

dass die flüssige Basiskomponente bezogen auf das Gesamtgewicht des Wärme transportierenden Mediums maximal 15 Gewichts% Nanofasermaterial enthält, vorzugsweise mit Polyvinylalkohol vorbehandeltes Nanofasermaterial, und/oder

dass die Basiskomponente bezogen auf das Gesamtgewicht 0,5 Gewichts% Nanofasermaterial enthält, und/oder

dass die Basiskomponente bezogen auf das Gesamtgewicht 1,0 Gewichts% Nanofasermaterial enthält, und/oder

dass die Basiskomponente bezogen auf das Gesamtgewicht 2,0 Gewichts% Nanofasermaterial enthält, und/oder

dass die Basiskomponente bezogen auf das Gesamtgewicht 4,0 Gewichts% Nanofasermaterial enthält, und/oder

dass die Basiskomponente bezogen auf das Gesamtgewicht 8,0 Gewichts% Nanofasermaterial enthält, und/oder

dass das Nanofasermaterial von einer Nanofaser des Typs "Pyrograf III" gebildet ist, und/oder

dass das Nanofasermaterial von einem Material des Typs "HTF 150 FF-HHT" gebildet ist, und/oder

dass die Basiskomponente Polyvinylalkohol und Nanofasermaterial enthält, und/oder

dass es als Kühlmedium in einem Kühlsystem mit wenigstens einem von dem Wärme transportierenden Medium durchströmten inneren Kühler oder Wärmetauscher und wenigstens einem von dem Wärme transportierenden Medium durchströmten äußeren Kühler verendet ist.

Nanofasermaterial im Sinne der Erfindung sind Nanotubes und/oder Nanofasern aus einem Material mit hoher Wärmeleitfähigkeit, insbesondere Nanotubes und/oder Nanofasern auf Karbon- oder Kohlenstoff-Basis. Weiterbildungen der Erfindung sind Gegenstand der Unteransprüche.

Die Erfindung wird im Folgenden anhand der Figuren an Ausführungsbeispielen näher erläutert. Es zeigen:

Fig. 1   in sehr schematischer Darstellung eine Anordnung zur Messung des thermischen Widerstandes eines flüssigen Wärme transportierenden Mediums;

Fig. 2   die Temperatur des Heizers und des Kühlers der Messanordnung der Figur 1 in Abhängigkeit von der Konzentration des Kohlenstoff-Nanofasermaterials in dem flüssigen Wärme transportierenden Mediums bzw. deren Basiskomponente;

Fig. 3   in einer Graphik den gemessenen Wärmewiderstand Rth in Abhängigkeit von dem Anteil an Kohlenstoff-Nanofasermaterial, auch im Vergleich mit Wasser ohne Zusatz und mit Wasser mit einem PVA-Zusatz als Wärme transportierendes Medium;

Fig. 4   ein Beispiel für eine Anwendung des flüssigen wärmetransportierenden Mediums gemäß der Erfindung als Kühlmittel.

Das wärmetransportierende Medium besteht aus einer Suspension aus Wasser als Basiskomponente und Nanofasermaterial, das bei dieser Ausführungsform der Erfindung zumindest zum überwiegenden Teil aus Nanotubes und/oder Nanofasern auf Kohlenstoffbasis besteht und zur Stabilisierung der Suspension vor dem Vermischen mit der Basiskomponente Wasser mit einem Polyvinylalkohol (PVA) vorbehandelt wurden. Diese Vorbehandlung z. B. erfolgt durch Mischen des Nanofasermaterials in einer PVA in höherer Konzentration enthaltenden Lösung, beispielsweise in einer Lösung mit einem PVA-Anteil von wenigstens 5 Gewichts% bezogen auf die Gesamtmasse der Lösung oder in einer gesättigten PVA-Lösung. Als Lösungsmittel dient hierbei z. B. Wasser.

Das so mit PVA vorbehandelte bzw. dotierte Nanofasermaterial wird dann mit einer ausreichenden Menge an Wasser zu der das wärmetransportierende Medium bildenden wässrigen Suspension gemischt, wobei der Anteil an vorbehandeltem Nanofasermaterial in dem wärmetransportierenden Medium vorzugsweise kleiner als 15 - 20 Gewichts% bezogen auf das Gesamtgewicht des wärmetransportierenden Mediums ist, um für dieses ein optimales Strömungsverhalten zu gewährleisten, wie dies beispielsweise bei Verwendung als ein Kühler, Wärmetauscher oder dgl. durchströmendes Kühlmedium notwendig ist. Durch die Vorbehandlung mit PVA ist das Nanofasermaterial in Wasser gut dispergierbar, sodass das wärmetransportierende Medium eine stabile Suspension bildet.

Durch die Vorbehandlung des Nanofasermaterials mit PVA bzw. durch das Aufbringen von PVA auf das Nanofasermaterial wird weiterhin auch ein Schmier- oder Gleiteffekt erreicht, und zwar u. a. mit dem Vorteil, dass das wärmetransportierende Medium Kanäle, Kammern oder dgl. schonend durchströmt und ein Abrieb an Innenflächen insbesondere auch von engen Kanälen, Kammern oder dgl. wirksam verhindert ist. Durch die PVA-Vorbehandlung wird weiterhin auch ein Verklumpen des Nanofasermaterials in dem wärmetransportierenden Medium verhindert.

Als Nanofasermaterial eignen sich beispielsweise Nanofasern, die unter den Bezeichnungen "Pyrograf III" oder "HTF 150 FF-HHT" von der Electrovac AG, A-3400 Klosterneuburg, Österreich angeboten werden. Weitere, bei der Erfindung als Nanofasermaterial verwendbare Nanofasern, die ebenfalls von der Electrovac AG, A-3400 Klosterneuburg, Österreich angeboten werden, sind in der nachstehenden Tabelle aufgeführt.

Tabelle 1

| Nano-faser | Nano-fasertyp | N2 Spezifische Oberfläche [m2/g] | Durchmesser [nm] | Länge [μm] | Wärmeleitfähigkeit [W/mK] | Elektrischer Widerstand [Ohm/cm] | Metallgehalt [wt. %] | Dichte [g/cm3] |
|---|---|---|---|---|---|---|---|---|
| | | | | | | | | |
| HTF150FF | AGF | 10-20 | 100-200 | >10 | > 600 | < 10⁻³ | < 0,5 | 1,95 |
| HTF150FF | PSF | 20-30 | 100-200 | >10 | > 600 | < 10⁻³ | < 0,5 | 1,95 |
| HTF150FF | LHT | 15-20 | 100-200 | >10 | > 600 | < 10⁻³ | <0,5 | > 1,95 |
| HTF150FF | HHT | 15-25 | 100-200 | >10 | > 600 | < 10⁻³ | < 0,01 | > 1,95 |
| HTF110FF | AGF | 53 | 70-150 | >10 | >600 | <10⁻³ | < 0,5 | 1,95 |
| HTF110FF | PSF | 50-60 | 70-150 | >10 | > 600 | < 10⁻³ | < 0,5 | 1,95 |
| HTF110FF | LHT | 43 | 70-150 | >10 | > 600 | < 10⁻³ | < 0,5 | > 1,95 |
| HTF110F F | HHT | 41 | 70-150 | >10 | > 600 | <10⁻³ | <0,01 | > 1,95 |
| ENF100AA | HTE | 80-100 | 80-150 | >10 | > 600 | < 10⁻³ | < 0,5 | 1,98 |

(fortgesetzt)

| Nano-faser | Nano-fasertyp | N2 Spezifische Oberfläche [m2/g] | Durchmesser [nm] | Länge [μm] | Wärmeleitfähigkeit [W/mK] | Elektrischer Widerstand [Ohm/cm] | Metallgehalt [wt. %] | Dichte [g/cm3] |
|---|---|---|---|---|---|---|---|---|
| ENF100AA | GFE | > 50 | 80-150 | >10 | > 600 | <10$^{-3}$ | < 0,01 | 2,17 |

Nanofasertyp:

AGF wie gewachsen
PSF pyrolytische stripped Carbon Nanofaser
LHT ausgeheizt bei ~ 1 000°C
HHT ausgeheizt bei ~ 3000°C
HTE ausgeheizt bei ~ 1000°C bei EVAC
GFE ausgeheizt bei ~ 3000°C bei EVAC

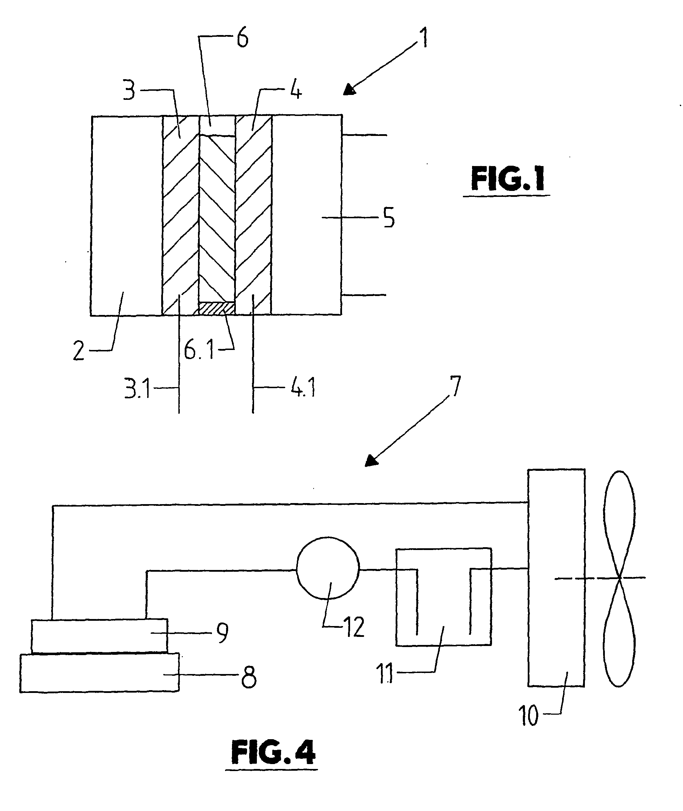

In der Figur 1 ist 1 eine Messanordnung, die zum Messen des thermischen Widerstandes Rth eines flüssigen wärmetransportierenden Mediums geeignet ist und im Wesentlichen aus einem elektrischen Heizer 2 an einer Oberflächenseite einer ersten, aus Kupfer bestehenden Platte 3, aus einer zweiten, ebenfalls aus Kupfer bestehenden Platte 4 und aus einem an einer Oberflächenseite dieser Platte vorgesehenen Kühler 5 besteht. Letzterer ist beispielsweise als passiver, d. h. durch die Umgebungsluft gekühlter Kühler oder aber als aktiver, d. h. als von einem Kühlmedium, nämlich von Wasser durchströmter Kühler ausgebildet. Die Platten 3 und 4 sind mit dem Heizelement 2 bzw. dem Kühler 5 jeweils flächig und thermisch in optimaler Weise, beispielsweise auch unter Verwendung einer in ihren Eigenschaften bekannten Wärmeleitpaste verbunden. Weiterhin sind die Platten 3 und 4 jeweils mit einem Temperatursensor 3.1 bzw. 4.1 zur Messung der Temperatur T1 der Platte 3 und der Temperatur T2 der Platte 4 versehen. Zwischen den einander zugewandten Seiten der Platten 3 und 4 ist ein Messspalt 6 gebildet, der bei der Messung vollständig von dem zu messenden wärmetransportierenden Medium ausgefüllt und durch eine entsprechende Dichtung 6.1 seitlich begrenzt ist, die ein unerwünschtes Herauslaufen des wärmetransportierenden Mediums aus dem Messspalt 6 verhindert und außerdem die Breite des Messspaltes 6 bzw. den Abstand der beiden Platten 3 und 4 definiert. Bei der dargestellten Ausführungsform beträgt die Breite des Messspaltes etwa 100 μm.

Der thermische Widerstand ist dabei, wie folgt, definiert:

$$Rth\ (°K/W) = (T1 - T2)/\text{Leistung des Heizelementes 2 in W}$$

Mit der Messanordnung 1 wurde der thermische Widerstand verschiedener Proben gemessen, die das mit PVA vorbehandelte Nanofasermaterial in unterschiedlichen Konzentrationen enthielten, und zwar mit 0.5, 1.0, 2.0, 4.0 und 8.0 Gewichts%, jeweils bezogen auf das Gesamtgewicht bzw. die Gesamtmasse des wärmetransportierenden Mediums.

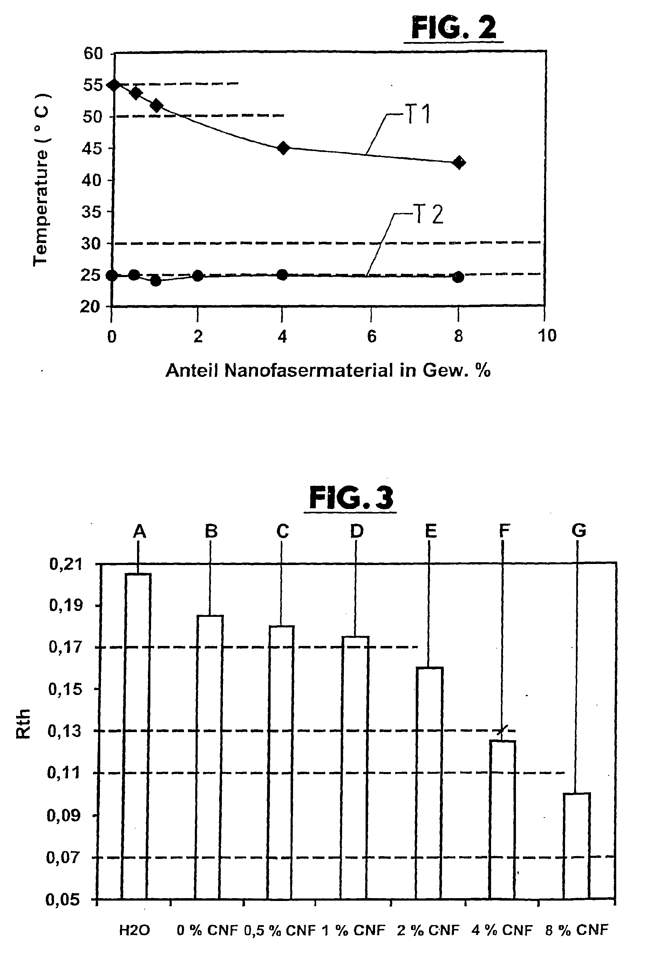

In der Figur 2 sind die gemessenen Temperaturen T1 und T2 angegeben. Während die Temperatur T2 der Messplatte 4 bzw. des Kühlers 5 im Wesentlichen konstant ist, nimmt die Temperatur der Platte 3 bzw. des Heizelementes 2 mit zunehmender Konzentration an Nanofasermaterial im wärmetransportierenden Medium ab, was bedeutet, dass der thermische Widerstand Rth mit zunehmendem Anteil an Nanofasermaterial abnimmt bzw. umgekehrt die thermische Leitfähigkeit des Materials mit zunehmendem Anteil an Nanofasermaterial zunimmt.

Die Figur 3 zeigt den sich aus der Temperaturdifferenz T1 und T2 jeweils ergebenden thermischen Widerstand, und zwar für verschiedene Proben A - G, wobei diese Proben folgende Zusammensetzung aufweisen:

Probe A:  Wasser ohne weitere Zusätze

Probe B:  Wasser mit PVA in einem Anteil von etwa 5 Gewichts%

Probe C:  Wasser und 0,5 Gewichts% an mit PVA vorbehandelten Nanofasermaterial

Probe D:  Wasser mit 1,0 Gewichts% an mit PVA vorbehandelten Nanofasermaterial

Probe E:     Wasser mit 2,0 Gewichts% an mit PVA vorbehandelten Nanofasermaterial

Probe F:     Wasser mit 4,0 Gewichts% an mit PVA vorbehandelten Nanofasermaterial

Probe G:     Wasser mit 8 Gewichts% an mit PVA vorbehandelten Nanofasermaterial jeweils bezogen auf das Gesamtgewicht der Probe.

Bereits bei einem Anteil von 0,5 Gewichts% Nanofasermaterial ergibt sich gegenüber reinem Wasser eine Reduzierung des thermischen Widerstandes Rth um etwa 12%. Bei einem Anteil von 4 Gewichts% an Nanofasern wird eine Reduzierung des thermischen Widerstandes Rth gegenüber Wasser von etwa 38 % erreicht.

Die Verwendung von PVA für die Vorbehandlung des Nanofasermaterials bzw. für die Stabilisierung des flüssigen wärmetransportierenden Mediums bietet auch den Vorteil, dass PVA toxikologisch unbedenklich und auch biologisch zumindest teilweise abbaubar und damit umweltverträglich ist.

Die Figur 4 zeigt in schematischer Darstellung ein in dieser Figur allgemein mit 7 bezeichnetes Kühlsystem zur Kühlung eines elektrischen Bauelementes, beispielsweise eines Prozessors 8 eines Rechners. Das wärmetransportierende Medium gemäß der Erfindung wird in diesem Kühlsystem 7 als Kühlmittel verwendet. Das Kühlsystem besteht in an sich bekannter Weise aus einem auf dem Prozessor 8 befestigten, von dem Kühlmittel durchströmbaren Bauelement-Kühler 9 und aus einem an der Außenseite des Gehäuses des Rechners vorgesehenen, ebenfalls von dem Kühlmedium durchströmten Außenkühler 10 mit entsprechendem Lüfter. Das Kühlsystem 7 umfasst weiterhin wenigstens einen Vorratsbehälter oder Reservoir 11 für das Kühlmittel sowie eine Umwälzpumpe 12, die zusammen mit dem Kühler 9 und dem Außenkühler 10 in einem geschlossenen Kühlmedium-Kreislauf angeordnet sind.

Durch die Reduzierung des thermischen Widerstandes des wärmetransportierenden Mediums und durch die damit einhergehende verbesserte Wärmeübertragung von dem Bauelement-Kühler 9 an das wärmetransportierende Medium bzw. Kühlmedium kann die Leistung des Kühlsystems 7, d. h. die je Zeiteinheit von dem Prozessor 8 abgeführte Wärmemenge wesentlich gesteigert werden.

**Bezugszeichenliste**

| | |
|---|---|
| 1 | Messanordnung |
| 2 | Heizelement |
| 3, 4 | Messplatte |
| 3.1, 4.1 | Temperatursensor |
| 5 | Kühler |
| 6 | Messspalt |
| 6.1 | Dichtung |
| 7 | Kühlkreis |
| 8 | elektrisches Bauelement, beispielsweise Prozessor |
| 9 | Bauelementkühler |
| 10 | Außenkühler |
| 11 | Reservoir für Kühlmedium |
| 12 | Umwälzpumpe |

**Patentansprüche**

1. Heiz- oder Kühlsystem mit wenigstens einem von einem Wärme transportierenden Medium durchströmten Wärmetauscher oder Kühler (9, 10),
   wobei das Wärme transportierendes Medium aus einer zumindest teilweise von Wasser gebildeten flüssigen Matrix- oder Basis-Komponente mit einem Zusatz in Form wenigstens eines Polyvinylalkohol (PVA) besteht,
   **dadurch gekennzeichnet,**
   **dass** die flüssige Matrix- oder Basis-Komponente weiterhin ein Nanofasermaterial enthält.

2. Heiz- oder Kühlsystem nach Anspruch 1, **dadurch gekennzeichnet, dass** die flüssige Matrix- oder Basis-Komponente ein mit dem Polyvinylalkohol vorbehandeltes und/oder versehenes Nanofasermaterial enthält.

3. Heiz- oder Kühlsystem nach Anspruch 1 oder 2, **dadurch gekennzeichnet,**das Nanofasermaterial ein solches auf Carbon- oder Kohlenstoffbasis ist.

4. Heiz- oder Kühlsystem nach einem der vorhergehenden Ansprüche, **dadurch gekennzeichnet, dass** das Nanofasermaterial Nanofasern und/oder Nanotubes enthält.

5. Heiz- oder Kühlsystem nach einem der vorhergehenden Ansprüche, **dadurch gekennzeichnet, dass** das Nanofasermaterial durch Vermischen mit einer Polyvinylalkohol enthaltenden Vorbehandlungslösung vorbehandelt ist, wobei die Vorbehandlungslösung beispielsweise 5Gewichts% Polyvinylalkohol enthält oder eine gesättigte Polyvinylalkohol-Lösung ist..

6. Heiz- oder Kühlsystem nach einem der vorhergehenden Ansprüche, **dadurch gekennzeichnet, dass** die flüssige Basiskomponente bezogen auf das Gesamtgewicht des Wärme transportierenden Mediums maximal 15 Gewichts% Nanofasermaterial enthält, vorzugsweise mit Polyvinylalkohol vorbehandeltes Nanofasermaterial.

7. Heiz- oder Kühlsystem nach einem der vorhergehenden Ansprüche, **dadurch gekennzeichnet, dass** die Basiskomponente bezogen auf das Gesamtgewicht 0,5 Gewichts% oder 1,0 Gewichts% oder 2,0 Gewichts% oder 4,0 Gewichts% oder 8,0 Gewichts% Nanofasermaterial enthält.

8. Heiz- oder Kühlsystem nach einem der vorhergehenden Ansprüche, **gekennzeichnet durch** seine Ausbildung als Kühlsystem für elektrische Bauelemente (8).

**Claims**

1. Heating or cooling system with at least one heat exchanger or cooler (9, 10) through which a heat-transporting medium flows, wherein the heat-transporting medium consists of a liquid matrix or base component formed at least in part by water and having an additive in the form of at least one polyvinyl alcohol (PVA), **characterised in that** the liquid matrix or base component contains furthermore a nanofibre material.

2. Heating or cooling system according to claim 1 **characterised in that** the liquid matrix or base component contains a nanofibre material pre-treated and/or provided with the polyvinyl alcohol.

3. Heating or cooling system according to claim 1 or 2 **characterised in that** the nanofibre material is a nanofibre material based on carbon or carbon base.

4. Heating or cooling system according to one of the preceding claims **characterised in that** the nanofibre material contains nanofibres and/or nanotubes.

5. Heating or cooling system according to one of the preceding claims, **characterised in that** the nanofibre material is pre-treated by mixing with a pre-treatment solution containing polyvinyl alcohol, wherein the pre-treatment solution contains by way of example 5 % by weight polyvinyl alcohol or is a saturated polyvinyl alcohol solution.

6. Heating or cooling system according to one of the preceding claims **characterised in that** the liquid base component contains in relation to the overall weight of the heat-transporting medium a maximum 15% by weight nanofibre material, preferably nanofibre material pre-treated with polyvinyl alcohol.

7. Heating or cooling system according to one of the preceding claims **characterised in that** the base component contains in relation to the overall weight 0.5 % by weight or 1.0% by weight or 2.0% by weight or 4.0% by weight or 8.0% by weight nanofibre material.

8. Heating or cooling system according to one of the preceding claims **characterised by** its design as a cooling system for electrical components (8).


**Revendications**

1. Système de chauffage ou de refroidissement avec au moins un échangeur de chaleur ou dispositif de refroidissement (9, 10) traversé par un milieu transportant la chaleur,
le milieu transportant la chaleur se composant d'un composant liquide de matrice ou de base, formé, du moins en partie, d'eau avec un additif sous la forme d'au moins un alcool polyvinylique,
**caractérisé en ce**
**que** le composant liquide de matrice ou de base contient par ailleurs un matériau à nanofibres.

2. Système de chauffage ou de refroidissement selon la revendication 1, **caractérisé en ce que** le composant liquide de matrice ou de base contient un matériau à nanofibres doté et/ou préalablement traité par l'alcool polyvinylique.

3. Système de chauffage ou de refroidissement selon la revendication 1 ou 2, **caractérisé en ce que** le matériau à nanofibres est à base de carbone.

4. Système de chauffage ou de refroidissement selon l'une des revendications précédentes, **caractérisé en ce que** le matériau à nanofibres contient des nanofibres et/ou des nanotubes.

5. Système de chauffage ou de refroidissement selon l'une des revendications précédentes, **caractérisé en ce que** le matériau à nanofibres est préalablement traité par mélange avec une solution de traitement préalable contenant un alcool polyvinylique, la solution de traitement préalable contenant par exemple 5% en poids d'alcool polyvinylique ou une solution saturée d'alcool polyvinylique.

6. Système de chauffage ou de refroidissement selon l'une des revendications précédentes, **caractérisé en ce que**, par rapport au poids total du milieu transportant la chaleur, le composant liquide de base contient maximum 15% en poids de matériau à nanofibres, de préférence un matériau à nanofibres traité préalablement avec de l'alcool polyvinylique.

7. Système de chauffage ou de refroidissement selon l'une des revendications précédentes, **caractérisé en ce que** le composant de base, par rapport au poids total contient 0,5% en poids ou 1,0 % en poids ou 2,0% en poids ou 4,0% en poids ou 8,0% en poids de matériau à nanofibres.

8. Système de chauffage ou de refroidissement selon l'une des revendications précédentes, **caractérisé par** sa conception en tant que système de refroidissement pour des composants électriques (8).

**FIG.1**

**FIG.4**

## FIG. 2

## FIG.3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1055719 A1
- GB 1066333 A
- US 2005037082 A1
- JP 2004185983 A